# EUROPÄISCHE PATENTANMELDUNG

(11) **EP 1 298 723 A2**
(43) Veröffentlichungstag der Anmeldung: **02.04.2003**
(21) Anmeldenummer: 02021388.0
(22) Anmeldetag: 24.09.2002
(51) Int. Cl.: H01L 23/31, H01L 21/68

(54) **Elektronisches Bauteil mit einem Kunststoffgehäuse und Komponenten eines Systemträgers und Verfahren zu deren Herstellung**

(30) Priorität: 28.09.2001 DE 10148043
(71) Anmelder: Infineon Technologies AG, 81669 München (DE)
(72) Erfinder: Paulus, Stefan, 93197 Zeitlarn (DE); Gabler, Franz, 93138 Kareth (DE)
(74) Vertreter: Schweiger, Martin, Dipl.-Ing.

(57) **Zusammenfassung**

Die Erfindung betrifft ein elektronisches Bauteil (1) mit einem Kunststoffgehäuse (2) und Komponenten eines Systemträgers (4) und Verfahren zu deren Herstellung. Dabei weist das elektronische Bauteil (1) in seinem Kunststoffgehäuse Inseln (3) eines höhenstrukturierten Systemträgers (4) auf, wobei die höhenstrukturierten Inseln auf der Unterseite eines Kunststoffgehäuses in einer Matrix angeordnet sind. Die Chipinseln selbst werden als Kontaktinseln (7) zur Aufnahme von Bondanschlüssen auf ihren Oberseiten (24) und als Chipinseln zur Aufnahme von Halbleiterchips (20) ausgeführt.

## Beschreibung

Die Erfindung betrifft ein elektronisches Bauteil mit einem Kunststoffgehäuse und Komponenten eines höhenstrukturierten metallischen Systemträgers und Verfahren zur Herstellung derselben gemäß der Gattung der unabhängigen Ansprüche.

Zum Aufbau von flachleiterfreien Gehäusen wie TSLP-Gehäusen (thin small leadless packages) sind für jede Gehäuseform neue und voneinander unterschiedliche Systemträger erforderlich. Dieses hat den Nachteil kostenintensiver logistischer Aufwendungen, hoher Umrüstzeiten für entsprechende Bestückungs- und Bondanlagen und erfordert eine große Lagerhaltung.

Aufgabe der Erfindung ist es, ein elektronisches Bauteil mit einer Gehäusebauform anzugeben, das einen derartigen kostenintensiven Aufwand vermeidet.

Gelöst wird diese Aufgabe mit dem Gegenstand der unabhängigen Ansprüche. Vorteilhafte Weiterbildungen ergeben sich aus den abhängigen Ansprüchen.

Erfindungsgemäß weist das elektronische Bauteil ein Kunststoffgehäuse auf, in dem Komponenten eines höhenstrukturierten metallischen Systemträgers eingebaut sind. Diese Komponenten sind metallische Inseln in dem Kunststoffgehäuse, die auf der Unterseite des Kunststoffgehäuses in einer Matrix angeordnet sind. Von diesen Inseln dient ein Teil als Chipinseln, auf denen ein Halbleiterchip angeordnet ist und ein anderer Teil als Kontaktinseln, die Bondanschlüsse auf ihren Oberseiten und Außenkontaktflächen auf ihren Unterseiten aufweisen. Mit einer derartigen Matrix, in der bei gleichbleibendem Rastermaß höhenstrukturierte Inseln auf einem metallischen Systemträger zur Verfügung gestellt werden, ist es in vorteilhafter Weise möglich, Halbleiterchips von kleinsten Abmessungen, wie sie bei Hochfrequenzschaltungselementen wie PIN-Dioden oder Hochfrequenztransistoren auftreten, unterzubringen, wobei diese Hochfrequenzschaltungselemente von bis zu neun Kontaktinseln umgeben sind, wenn lediglich eine Chipinsel für die Aufnahme des Halbleiterchips erforderlich ist und von einer quadratischen Gehäusestruktur ausgegangen wird. Andererseits können auch beliebig große Halbleiterchips, wie sie für Logikbausteine und Speicherbausteine eingesetzt werden, auf einem derartigen höhenstrukturierten Systemträger mit einer Matrix aus Inseln aufgebracht werden, wobei die Anzahl der umgebenden Kontaktinseln einerseits von der Größe des Halbleiterchips abhängt und andererseits beliebig durch zusätzliche reihenförmig oder ringförmig angeordnete Kontaktinseln vergrößert werden kann.

Somit kann für eine große Anzahl Gehäusebauformen ein einziger mit einer Matrix aus höhenstrukturierten Inseln ausgestatteter Systemträger eingesetzt werden. Dabei verbleiben von dem Systemträger lediglich die höhenstrukturierten Inseln in Form von Chipinseln, soweit sie einen Halbleiterchip aufnehmen, und Kontaktinseln, soweit sie für Bondanschlüsse als Komponenten des elektronischen Bauteils in der Kunststoffgehäusemasse zur Verfügung gestellt werden. Außerdem kann der Systemträger beliebig viele Kontaktinseln in der Umgebung der Chipinseln bereitstellen, um den Kontaktflächen auf der aktiven Oberseite der Halbleiterchips zu entsprechen.

In einer Ausführungsform der Erfindung sind die Inseln in der Matrix unter- und nebeneinander in Zeilen und Spalten angeordnet. Durch das Unter- und Nebeneinanderanordnen der Inseln in der Matrix kann ein Rastermaß erreicht werden, das nach unten lediglich durch die geforderte Kriechstromfestigkeit und Spannungsfestigkeit für das elektronische Bauteil begrenzt wird und ansonsten von dem Rastermaß des übergeordneten Systems wie einer Leiterplatte bestimmt wird. Damit wird gleichzeitig auch die Dichte der Außenkontaktanschlüsse auf der Unterseite des elektronischen Bauteils begrenzt.

In einer weiteren Ausführungsform der Erfindung sind die Inseln in der Matrix versetzt zueinander in Zeilen und Spalten angeordnet. Mit dieser versetzten Anordnung kann bei gleicher Kriechstromfestigkeit und gleicher Spannungsfestigkeit für jedes elektronische Bauteil eine höhere Außenkontaktdichte auf der Unterseite des elektronischen Bauteils erreicht werden. In einer weiteren Ausführungsform der Erfindung weisen die Inseln gleiche Abmessungen im Hinblick auf Materialstärke, Breite und Tiefe auf. Dabei bestimmt die Materialstärke das Einbetten der Inseln in das Kunststoffgehäuse, während die Breite und die Tiefe die Größe der Außenkontaktflächen definiert.

In einer weiteren Ausführungsform der Erfindung können die Inseln eine zylindrische Struktur aufweisen. Auch hier bestimmt die Höhe der zylindrischen Struktur das Einbetten in die Kunststoffpressmasse, während die Grundfläche des Zylinders gleichzeitig die Größe der Außenkontaktflächen bestimmt. Inseln von zylindrischer Struktur haben den Vorteil gegenüber rechteckigen oder quadratischen Inseln, dass sie keine Ecken und damit keine Feldstärkespitzen aufweisen.

Ein Kompromiss zwischen beiden Formen, nämlich der rechteckigen bzw. quadratischen Form und der kreisförmigen Form der Inseln liefert eine Inselform mit polygonalem Querschnitt. Bei dieser Form sind die Feldstärkespitzen in den Ecken durch Bilden stumpfer Winkel stärker abgeschwächt als bei rein quadratischer oder rechteckiger Form der Inseln.

Bei einer weiteren Ausführungsform der Erfindung weisen die Inseln zur Unterseite des elektronischen Bauteils hin einen sich vermindernden Querschnitt auf. Bei einer derartigen Höhenstruktur der Inseln wird eine formschlüssige Verankerung der Inseln in der Kunststoffgehäusemasse erreicht. Diese Querschnittsverminderung kann auch abrupt vorgesehen sein, indem die Inseln eine nagelkopfförmige Vergrößerung zu ihrer Oberseite hin aufweisen.

Eine weitere Ausführungsform der Erfindung sieht vor, dass die Inseln Kupfer, Nickel, Silber oder Legierungen derselben aufweisen. Dieses hat einerseits den Vorteil, dass beispielsweise Kupfer oder Kupferlegierungen eine hohe elektrische Leitfähigkeit aufweisen und dass Kupfer äußerst duktil ist, so dass ein höhenstrukturierter Systemträger zum Aufbau eines erfindungsgemäßen elektronischen Bauteils bereits durch einfaches Prägen von höhenstrukturierten Inseln auf einer Kupferplatte oder einem Kupferband realisierbar ist. Sind die Inseln aus Nickel oder Silber oder Legierungen derselben und das Trägermaterial des Systemträgers aus Kupfer oder Kupferlegierungen, so bildet der Übergang von einem Metall auf das andere eine Trennzone, an der die Inseln von dem Trägermaterial getrennt werden können, indem beispielsweise ein Ätzvorgang gestoppt wird.

Die Oberseiten der Inseln können für ihren Einsatz als Kontaktinseln durch eine auf der Oberseite abgeschiedene bondbare Beschichtung verbessert werden. Gleichzeitig kann bei der Bildung der bondbaren Beschichtung eine nagelkopfförmige Form oder Pilzform zur Verankerung der Inseln in der Kunststoffpressmasse erreicht werden. Eine derartige Beschichtung kann in einer weiteren Ausführungsform der Erfindung Gold, Palladium, Silber, Aluminium und/oder Legierung derselben als bondbare Beschichtung aufweisen. Diese Materialien haben den Vorteil, dass sie mit den Bonddrähten zur Verbindung von Kontaktflächen auf der Oberseite der Halbleiterchips mit Kontaktanschlussflächen auf den Kontaktinseln besonders geeignet sind.

Eine weitere Ausführungsform der Erfindung sieht vor, dass die Oberseiten der Chipinseln eine lötbare Beschichtung aufweisen. Mit einer derartigen lötbaren Beschichtung ist es möglich, die Halbleiterchips vor dem Aufbringen von Bondverbindungen auf den Oberseiten der Chipinseln zu fixieren. Andere Möglichkeiten der Fixierung und gleichzeitig elektrischen Kontaktgabe bestehen darin, einen leitfähigen Klebstoff zwischen den Bondinseln und den Halbleiterchips vorzusehen. Bei Anwendungen, bei denen keine elektrische Verbindung zwischen Chipinseln und Halbleiterchips vorgesehen werden muss, sondern lediglich die Halbleiterchips auf den Chipinseln während des Anbringens von Bonddrähten zu fixieren sind, kann auch ein isolierender Klebstoff eingesetzt werden.

Als lötbare Beschichtung auf den Oberseiten der Chipinseln können in einer weiteren Ausführungsform der Erfindung die Oberseiten der Chipinseln eine Silberlotverbindung aufweisen. Diese Silberlotbeschichtung hat den Vorteil, dass sie an Luft nicht oxidiert, sondern lediglich einen sulfidischen Überzug bildet, und somit kann ein höhenstrukturierter Systemträger für längere Zeit in großer Stückzahl gelagert werden, ohne dass sich die Lötbarkeit der Silberlotbeschichtung ändert.

Gemäß den Aufgaben des elektronischen Bauteils können für Hochfrequenzbauteile oder Niederfrequenzbauteile jeweils ein Halbleiterchip auf einer Chipinsel angeordnet sein, da die Halbleiterchips derartiger diskreter Bauelemente relativ geringe Oberflächen aufweisen. Für großflächige Halbleiterchips, die in der Logik- und Speicheranwendung einsetzbar sind, werden mehrere Chipinseln zum Stützen des großflächigen Halbleiterchips benötigt. Der auf Chipinseln angeordnete Halbleiterchip kann dabei mindestens von einer Reihe einseitig oder von einem Ring allseitig aus Kontaktinseln umgeben sein. Dabei verbinden Bonddrähte die Kontaktflächen auf der aktiven Oberseite der Halbleiterchips mit den Oberseiten der umgebenden Kontaktinseln. Somit ergibt sich der Vorteil, dass elektronische Bauteile mit einer Matrix aus höhenstrukturierten Inseln beliebig kleine und beliebig große Gehäuseformen aufweisen können, solange die auf der Unterseite verteilten Inseln in dem vorgegebenen Rastermaß der Matrix bleiben.

Für die oben aufgeführten elektronischen Bauteile wird ein Systemträger vorgeschlagen, der zwischen den höhenstrukturierten Inseln und einem Trägermaterial eine Trennschicht aufweist. Diese Trennschicht kann bei einem metallischen Systemträger aus einer Ätzstoppzone bestehen, die Nickel oder eine Nickellegierung aufweist. Bei anderen Trägermaterialien ist eine Trennschicht mit niedrigem Schmelzpunkt vorgesehen, so dass durch Erhitzen über dem Schmelzpunkt das Trägermaterial des Systemträgers von den höhenstrukturierten Inseln trennbar ist. Ein derartiger Systemträger hat den Vorteil, dass nach einem Aufbringen einer Kunststoffpressmasse und dem Einbetten der Chipinseln in diese Kunststoffpressmasse das Trägermaterial des Systemträgers entweder durch Ätzen oder durch Erhitzen von den in der Kunststoffpressmasse eingebetteten höhenstrukturierten Inseln trennbar ist.

In einer weiteren Ausführungsform der Erfindung ist der Systemträger in mehrere Bauteilpositionen einteilbar, wobei die Anzahl und Größe an die Größe des jeweiligen Halbleiterchips und an die Anzahl der auf dem Halbleiterchip angeordneten Kontaktflächen anpassbar ist. Somit können auf einem erfindungsgemäßen Systemträger beliebige Größen von Halbleiterchips in unterschiedliche Gehäuseformen eingepackt werden, ohne dass speziell angepasste Systemträger für die jeweiligen Halbleiterchips vorzusehen sind.

Eine weitere Ausführungsform der Erfindung sieht einen Nutzen vor, der mehrere in einer gemeinsamen Kunststoffpressmasse angeordnete elektronische Bauteile aufweist. Jedes Bauteil des Nutzens weist Inseln eines höhenstrukturierten Systemträgers aus. Die Inseln sind in einer Matrix aus Kontaktinseln und Chipinseln angeordnet, wobei die Chipinseln elektronische Schaltungselemente tragen und die Kontaktinseln mit den Chipinseln und/oder untereinander über Bondverbindungen innerhalb der Kunststoffpressmasse verbunden sind. Dabei bilden die Kunststoffpressmasse und der höhenstrukturierte Systemträger eine kompakte Verbundplatte. Ein derartiger Nutzen vereinfacht und verbilligt die Lagerhalterung, da er als kompaktes Zwischenprodukt den Abschluss einer Fertigungslinie bilden kann. Außerdem hat der Nutzen den Vorteil, dass beispielsweise eine Beschichtung der Außenkontaktflächen der Inseln nach einem Abtrag des Trägermaterials des Systemträgers in einem parallelen Verfahrensschritt für alle elektronischen Bauteile des Nutzens gleichzeitig durchgeführt werden kann.

Ein Verfahren zur Herstellung eines Systemträgers mit höhenstrukturierten Inseln weist zwei Verfahrensschritte auf, nämlich einmal das Bereitstellen eines Trägermaterials für einen höhenstrukturierten Systemträger in Form einer Platte oder eines Bandes und anschließend Bilden von höhenstrukturierten Inseln auf dem Trägermaterial in einer Matrix mit einheitlichem Rastermaß. Das Bilden von höhenstrukturierten Inseln auf dem Trägermaterial kann mit unterschiedlichen Verfahrensschritten erreicht werden, wobei eine Technik das Abscheiden von metallischen höhenstrukturierten Inseln umfasst. Ein anderes Verfahren besteht darin, aus einem mit einer Metallschicht versehenen Träger höhenstrukturierte Inseln herauszu-ätzen. Dabei kann das Trägermaterial sowohl aus einer isolierenden Platte oder einem isolierenden Band als auch aus einem Metallband bestehen. Im Falle des isolierenden Bandes ergibt sich ein Ätzstopp, sobald die metallische Schicht auf dem Isolierband bzw. auf der Isolierplatte durchgeätzt ist. Bei einem metallischen Trägermaterial ist es von Vorteil, wenn zwischen der Metallschicht für die höhenstrukturierten Inseln und dem Metall des Trägermaterials eine Ätzstoppzone vorgesehen ist. Gleiches gilt bei der Abscheidung auf unterschiedlichen Trägermaterialien.

Eine weitere Möglichkeit, höhenstrukturierte Inseln zu bilden, ist das Prägen von Inseln in eine entsprechende duktile Schicht oder in ein entsprechendes duktiles Trägermaterial. Dabei können die Inseln in einheitlichen vorbestimmten Rastermaßen angeordnet werden. Auch die Form der Inseln kann derart variiert werden, dass eine sichere Verankerung der Inseln in der Kunststoffpressmasse möglich wird. Deshalb werden Inseln mit einer Nagelkopfform oder Pilzform bevorzugt. Die Inseln selbst können aus leitendem, nichtleitendem oder halbleitendem Material aufgebaut sein. Die Kontaktinseln, die aus nichtleitendem Material aufgebaut sind, weisen eine leitende metallische vollständig die Kontaktinsel einhüllende Schicht auf, um eine Möglichkeit des elektrischen Zugriffs von der Unterseite der Kontaktinseln aus über entsprechende Bondanschlüsse auf der Oberseite der Kontaktinseln zu den Kontaktflächen auf der Oberseite der Halbleiterchips zu gewährleisten.

Je nach Vorbestimmung der höhenstrukturierten Inseln können diese auf ihren Oberseiten mit einer bondbaren Beschichtung oder mit einer lötbaren Beschichtung versehen werden. Eine bondbare Beschichtung wird dann aufgebracht, wenn die höhenstrukturierte Insel als Kontaktinsel verwendet werden soll, während eine lötbare Beschichtung auf Chipinseln aufgebracht werden kann, um einen elektrischen Kontakt zu der Unterseite des Halbleiterchips herzustellen oder um den Halbleiterchip für den Bondschritt zu fixieren.

Zum Bilden der Inseln können in einem speziellen Verfahren folgende weitere Verfahrensschritte durchgeführt werden.
- Aufbringen einer Maske auf einer Oberseite eines metallischen Trägermaterials mit einer Matrix aus freiliegenden Flächen des Trägermaterials für höhenstrukturierte in Zeilen und Spalten angeordnete Inseln,
- Aufbringen einer höhenstrukturierten Schicht mit Ätzstoppzone auf die freiliegenden Flächen des Trägermaterials unter Ausbildung von höhenstrukturierten Inseln eines Systemträgers einschließlich einer abschließenden bondbaren Beschichtung,
- Entfernen der Maske.

Mit diesem Verfahren wird ein Systemträger zur Verfügung gestellt, der unter jeder Insel eine Ätzstoppzone aufweist. Diese Ätzstoppzone verlangsamt das spätere Abätzen des Trägermaterials, so dass bei dem Abätzen lediglich die höhenstrukturierten Inseln nach dem Ätzen des Trägermaterials in einer Gehäusekunststoffpressmasse verbleiben.

Ein weiteres spezielles Verfahren zur Herstellung eines Nutzens aus einem Verbund aus Systemträgern mit höhenstrukturierten Inseln und einer Kunststoffpressmasse weist folgende zusätzliche Verfahrensschritte nach dem Entfernen der Maske auf:
- Aufbringen von Halbleiterchips auf die Chipinseln,
- Herstellen von Bondverbindungen zwischen Kontaktflächen des Halbleiterchips und Kontaktinseln und/oder zwischen Kontaktinseln,
- einseitiges Verpacken des Systemträgers für mehrere elektronische Bauteile in einer gemeinsamen Schicht aus Kunststoffpressmasse unter Einbetten der höhenstrukturierten Inseln, der Halbleiterchips und der Bondverbindungen in der Kunststoffpressmasse zu einem Nutzen.

Ein derartiges Verfahren hat den Vorteil, dass ein Nutzen entsteht, der im wesentlichen eine Verbundplatte aus Kunststoffpressmasse und Systemträger aufweist. Dieser Nutzen ist besonders stabil und kann von einem Fertigungsabschnitt zu einem weiteren Fertigungsabschnitt transportiert oder zwischengelagert werden und kann bereits ein Zwischenprodukt darstellen, das kommerziell verwertbar ist.

Ein Verfahren zur Herstellung eines elektronischen Bauteils mit einem Kunststoffgehäuse und Inseln eines höhenstrukturierten metallischen Systemträgers weist folgende zusätzliche Verfahrensschritte nach dem Herstellen eines Nutzens auf:
- Entfernen des Systemträgers mindestens bis zur Ätzstoppzone,
- Aufbringen einer Kontaktschicht auf die Unterseiten der Inseln zur Bildung von Außenkontakten auf der Unterseite des elektronischen Bauteils,
- Trennen des Nutzens mit Kunststoffpressmasse und höhenstrukturierten Inseln eines Systemträgers in einzelne elektronische Bauteile.

Dieses Verfahrensbeispiel geht von einem metallischen Träger aus, der in den verschiedenen Verfahrensschritten zu einem Nutzen für mehrere elektronische Bauteile bearbeitet wird, und schließlich wird dieser Nutzen in einzelne Bauteile getrennt. Dieses Verfahrensbeispiel hat den Vorteil, dass die meisten der vorliegenden Herstellungsschritte gleichzeitig, das heißt parallel für mehrere Bauteile durchgeführt werden können und erst bei vollständiger Fertigstellung der elektronischen Bauteile auf dem Nutzen kann dieser in Einzelbauteile getrennt wird.

In einem Durchführungsbeispiel eines Verfahrens zur Herstellung eines elektronischen Bauteils wird das Aufbringen einer Maske mittels Photolithographietechnik erfolgen. Dabei kann die Maske so hergestellt werden, dass für ein Abscheidungsverfahren, bei dem erhabene Inseln auf einem Trägermaterial zu einem höhenstrukturierten Systemträger abgeschieden werden sollen, die Oberflächenteile des Trägermaterials abgedeckt werden, auf denen keine Abscheidung stattfinden soll. Eine derartige Maske wird auch aufgebracht, wenn ein höhenstrukturierter Systemträger aus einem Trägermaterial durch Ätzen hergestellt werden soll. In dem Fall des Ätzens werden photolithographische Schichten in den Bereichen beibehalten, die als höhenstrukturierte Inseln stehen bleiben sollen.

Eine derartige Maske kann in einem weiteren Durchführungsbeispiel des Verfahrens mittels Drucktechnik, vorzugsweise Siebdrucktechnik oder Schablonendrucktechnik, aufgebracht werden. Im Unterschied zur Photolithographietechnik kann das Aufbringen einer Maske mittels Drucktechnik durch einen einzigen Verfahrensschritt erfolgen. Eventuell muss nach dem Aufbringen der Siebdruckmaske diese noch ausgehärtet werden, doch ist kein photolithographischer Schritt erforderlich, bei dem eine zusätzliche optische Maske einzusetzen wäre.

Bei einem Abscheideverfahren von höhenstrukturierten Inseln auf einem Trägermaterial zu einem höhenstrukturierten Systemträger ist es vorteilhaft, zunächst eine Ätzstoppzone mittels Aufstäubungstechnik wie Sputtertechnik oder Aufdampftechnik auf der maskierten Oberfläche des Trägermaterials aufzubringen. Dabei wird praktisch die Oberfläche des maskierten Trägermaterials vollständig verspiegelt. In gleicher Weise wirkt eine chemische Gasphasenabscheidung, bei der ebenfalls die ganze Oberfläche verspiegelt wird, so dass im Anschluss daran durch einen photolithographischen Schritt und einen Ätzschritt die Ätzstoppzone auf die Bereiche der höhenstrukturierten Inseln zu beschränken ist.

Ein derartiger Aufwand kann vermindert werden, wenn das Trägermaterial aus einem Metall besteht und die Ätzstoppzone auf freiliegenden Flächen galvanisch abgeschieden wird. Diese Verfahrensvariante hat den Vorteil, dass nur dort eine Ätzstoppzone aufwächst, bei der eine metallische Oberfläche des Trägermaterials freiliegt. Weiterhin kann auf dieser Ätzstoppzone unmittelbar eine höhenstrukturierte Schicht in den freigelegten Flächen in einem galvanischen Bad abgeschieden werden, wobei in vorteilhafter Weise Kupfer oder eine Kupferlegierung durch Einsatz eines Kupfervitriolbades abgeschieden wird.

Nachdem entweder durch Abscheidung oder durch Ätzen höhenstrukturierte Inseln auf einem Trägermaterial mit Hilfe der Maske hergestellt wurden, wird die Maske entfernt. Dieses erfolgt in einem weiteren Durchführungsbeispiel des Verfahrens mittels chemischer Lösungsmittel, wobei die Maske aus einem Polymer aufgelöst wird. Eine andere Möglichkeit wird in einem weiteren Durchführungsbeispiel des Verfahrens genutzt, indem durch eine Plasmaveraschung die Maske trocken entfernt wird. Bei diesem Prozess wird praktisch die Kunststoffpressmaske verbrannt, und die Aschereste können in einem einfachen Spülprozess weggespült werden. Dieses Verfahren hat den Vorteil, dass weniger umweltschädliche Lösungsmittel einzusetzen sind.

Das Aufbringen einer bondbaren Beschichtung auf Kontaktinseln wird in einer weiteren Ausführungsform der Erfindung mittels Aufstäubungstechnik oder Sputtertechnik erfolgen. Diese Aufstäubungstechniken können sehr präzise und auf die Kontaktinseln beschränkte bondbare Beschichtungen aufbringen. Dabei kann die Dicke dieser bondbaren Beschichtungen genau eingestellt werden und die Oberseiten der Kontaktinseln können mit Gold, Silber oder Aluminium oder mit deren Legierung bei einer Schichtdicke im Submikrometerbereich beschichtet werden.

Während das Aufbringen einer Lotschicht auf die Chipinseln mit aufwendigen Erwärmungsprozesses verbunden ist, kann ein Leitklebstoff, der elektrisch leitendes Füllmaterial in seinem Klebstoff aufweist, mittels Klebstofffolien auf die Chipinseln aufgebracht werden, was den Verfahrensschritt wesentlich erleichtert. Soll jedoch die Rückseite des Halbleiterchips mit den Chipinseln keine elektrische Verbindung eingehen, sondern lediglich auf den Chipinseln mechanisch befestigt werden, so wird anstelle eines Lotes oder eines Leitklebstoffs ein isolierender Klebstoff eingesetzt.

Nach dem Aufsetzen eines Halbleiterchips auf den Chipinseln können die Bondverbindungen mittels Thermokompressions-, Thermosonic- oder Ultraschallbonden zwischen Elektronen der Schaltungselemente und Kontaktinseln oder zwischen Kontaktinseln untereinander aufgebracht werden. Da unter den höhenstrukturierten Inseln das Trägermaterial noch vorhanden ist, ist ein Bonden auf den Kontaktinseln ohne Probleme möglich. Der Halbleiterchip hingegen weist zwischen den Chipinseln nicht gestützte Bereiche auf, was das Herstellen einer Bondverbindung mit den Kontaktflächen auf dem Halbleiterchip erschweren könnte. Dieses gilt nicht, wenn der Halbleiterchip eine ausreichende Dicke aufweist.

Das Verpacken in einer Kunststoffpressmasse kann in einem weiteren Durchführungsbeispiel mittels Spritzgusstechnik erfolgen. Bei dieser Technik wird über den gesamten Systemträger mit höhenstrukturierten Inseln ein Formwerkzeug angeordnet und zwischen Systemträger und Formwerkzeug eine Kunststoffpressmasse eingeführt. Dabei werden Chipinseln, Kontaktinseln und Bondverbindungen sowie der Halbleiterchip in die Kunststoffpressmasse eingebettet. Die Unterseite der Chipinseln und der Kontaktinseln wird dabei durch die Lötstoppzone vor Benetzung mit Kunststoff geschützt. Somit kann nach dem Spritzgießen der Kunststoffpressmasse der Systemträger bis zur Ätzstoppzone abgetragen werden, so dass auf der Unterseite der Kunststoffpressmasse eine Matrix von Außenkontaktflächen sichtbar wird.

Zusammenfassend ist festzustellen, dass mit dem erfindungsgemäßen Verfahren ein Muster von Inseln im Verhältnis 3 : 4 mittels Abscheidung, Ätzen, Stanzen, Prägen und so weiter erzeugt werden kann. Diese Inseln können in verschiedenen Rastern angeordnet werden. Die Inseln können in Form, Größe und in der Schrittweite variieren. Ebenfalls können die Inseln aus verschiedenen Materialien hergestellt werden. Auf der Oberseite der Inseln können geeignete Schichten zum Drahtbonden und zum Bonden des Chips auf Chipinseln aufgebracht sein. Außerdem sind Schichten auf den Inseln möglich, die eine Verbesserung der Verankerung der Inseln in der Kunststoffpressmasse bewirken.

Der Halbleiterchip kann auf den Chipinseln mittels Kleben, Löten oder mittels Legieren mechanisch befestigt werden und in Einzelfällen auch gleichzeitig elektrisch mit den Chipinseln verbunden werden. Dabei kann der Halbleiterchip auf einer einzelnen Insel oder gleichzeitig über mehrere Inseln reichen. Es ist auch möglich, bei entsprechend engem Rastermaß, einen Halbleiterchip in Flip-Chip-Technologie auf die höhenstrukturierten Inseln aufzubringen. Der Chip wird mittels Bonddrähten mit den chipumgebenden Kontaktinseln verbunden. Dies Verbinden mit Kontaktinseln kann einreihig oder beliebig vielreihig durchgeführt werden. Anschließend wird der gesamte Systemträger mit einer Kunststoffpressmasse vergossen oder versiegelt.

Die Verkapselung kann einen einzelnen Halbleiterchip oder gleich mehrere Chips auf einem Systemträger und damit für mehrere Gehäuse umfassen. Dabei wird die Kunststoffpressmasse auch unter dem Halbleiterchip zwischen den höhenstrukturierten Inseln verteilt. Nach der Verkapselung wird die Kunststoffplatte, die ein oder mehrere Gehäuse umfasst, vom Trägermaterial des Systemträgers mittels Ätzen oder mittels Erhitzen über einen Schmelzpunkt einer entsprechend vorbereiteten Trennschicht getrennt.

Nach der Trennung des Trägermaterials von den Kunststoffgehäusen können die Bauteile noch auf den Außenkontaktflächen der Inseln mit einer Zusatzschicht oder einem Lotdepot versehen werden. Dieses Lotdepot kann nur an den Außenkontäkten der Kontaktinseln oder zusätzlich auf die Außenkontakte der Chipinseln angebracht werden. Über das Lotdepot der Chipinseln kann beispielsweise ein elektrisches Potential an die Rückseite des Halbleiterchips gelegt werden und gleichzeitig die Wärmeableitung für das Halbleiterchip verbessert werden. Danach werden die verkapselten Bauteile mittels Sägen, Wasserstrahlschneiden, Laserschneiden oder anderen geeigneten Methoden vereinzelt. Diese Vereinzelung erfolgt an den möglichen Bauteilgrenzen, die aufgrund der einheitlichen Anordnung der Inseln in einem Abstand eines Vielfachen des Rastermaßes durchgeführt werden kann. Somit ermöglicht die Erfindung, mit einem Systemträgertyp mehrere unterschiedliche Bauformgrößen und Typen von elektronischen Bauteilen zu realisieren.

Die Erfindung wird nun anhand von Ausführungsformen mit Bezug auf die beiliegenden Zeichnungen näher erläutert.
- Figur 1: zeigt schematisch eine Draufsicht auf einen Ausschnitt mit zwölf Zeilen und zwölf Spalten von höhenstrukturierten Inseln eines höhenstrukturierten Systemträgers, wobei die Inseln in vier Bauteilpositionen eingeteilt sind, die jeweils einen Halbleiterchip und zwei den Halbleiterchip umgebende Ringe von Kontaktinseln aufweisen;
- Figur 2: zeigt schematisch eine Draufsicht auf einen Ausschnitt eines höhenstrukturierten Systemträgers mit in Zeilen und Spalten nebeneinander angeordneten höhenstrukturierten Inseln mit quadratischer Grundfläche;
- Figur 3: zeigt schematisch eine Draufsicht auf einen Ausschnitt eines höhenstrukturierten Systemträgers mit in Zeilen und Spalten versetzt zueinander angeordneten höhenstrukturierten Inseln mit quadratischer Grundfläche;
- Figur 4: zeigt schematisch eine Draufsicht auf einen Ausschnitt eines höhenstrukturierten Systemträgers mit in Zeilen und Spalten nebeneinander angeordneten Hähenstrukturierten Inseln mit kreisförmiger Grundfläche;
- Figur 5: zeigt schematisch eine Draufsicht auf einen Ausschnitt eines höhenstrukturierten Systemträgers mit in Zeilen und Spalten versetzt zueinander angeordneten höhenstrukturierten Inseln mit kreisförmiger Grundfläche;
- Figur 6: zeigt schematisch eine Draufsicht auf einen Ausschnitt, wie in Figur 1, mit zwölf Zeilen und zwölf Spalten von höhenstrukturierten Inseln eines höhenstrukturierten Systemträgers, wobei die Inseln in 16 Bauteilpositionen eingeteilt sind, die jeweils einen Halbleiterchip und einen den Halbleiterchip umgebenden Ring von Kontaktinseln aufweisen;
- Figur 7: zeigt schematisch eine Draufsicht auf einen Ausschnitt wie in Figur 1, mit zwölf Zeilen und zwölf Spalten von höhenstrukturierten Inseln eines höhenstrukturierten Systemträgers, wobei die Inseln in vier Bauteilpositionen eingeteilt sind, die jeweils einen Halbleiterchip und einen den Halbleiterchip umgebenden äußeren Ring von Kontaktinseln aufweisen;
- Figur 8: zeigt einen schematischen Querschnitt durch ein elektronisches Bauteil mit einem Kunststoffgehäuse und 81 höhenstrukturierten Inseln, bei dem ein Halbleiterchip auf 25 Chipinseln angeordnet ist und der Halbleiterchip von zwei Ringen aus insgesamt 56 Kontaktinseln umgeben ist;
- Figur 9: zeigt einen schematischen Querschnitt durch einen Ausschnitt eines Nutzens mit 64 höhenstrukturierten Inseln, bei dem in vier Bauteilpositionen jeweils ein Halbleiterchip auf vier Chipinseln angeordnet ist und jeder Halbleiterchip von sechzehn Kontaktinseln umgeben ist;
- Figur 10: zeigt einen schematischen Querschnitt durch eine höhenstrukturierte Insel mit Beschichtungen auf ihrer Oberseite und ihrer Unterseite;
- Figur 11: zeigt einen schematischen Querschnitt durch ein elektronisches Bauteil wie in Figur 8;
- Figur 12: zeigt einen schematischen Querschnitt durch ein elektronisches Bauteil, wie in Figur 8 und Figur 11;
- Figuren 13 bis 19: zeigen schematisch im Querschnitt eine schrittweise Herstellung eines Systemträgers eines Nutzens und eines elektronischen Bauteils mit höhenstrukturierten Inseln.

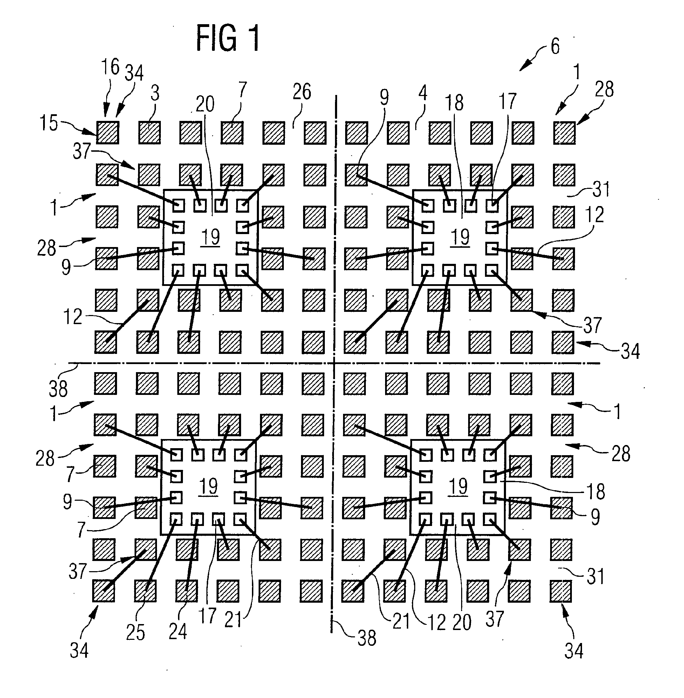

Figur 1 zeigt schematisch eine Draufsicht auf einen Ausschnitt mit zwölf Zeilen 15 und zwölf Spalten 16 von höhenstrukturierten Inseln 3 eines höhenstrukturierten Systemträgers 4, wobei die Inseln 3 in vier Bauteilpositionen 28 eingeteilt sind, die jeweils einen Halbleiterchip 20 und zwei den Halbleiterchip 20 umgebende Ringe 34 und 37 von Kontaktinseln 7 aufweisen. Das Bezugszeichen 1 kennzeichnet ein elektronisches Bauteil, von dem unter Weglassen der Kunststoffverpackung vier Bauteile 1 auf dem Ausschnitt eines Systemträgers 4 gezeigt werden.

Die höhenstrukturierten Inseln 3 sind in einer Matrix in diesem Ausschnitt eines Systemträgers angeordnet, wobei die Matrix in diesem Ausschnitt zwölf Zeilen und zwölf Spalten mit höhenstrukturierten Inseln 3 in Figur 1 zeigt. In den hier gezeigten vier Bauteilpositionen 28 ist jeweils im Zentrum einer Bauteilposition 28 ein Halbleiterchip 20 angeordnet, der auf seiner Oberfläche 19 Kontaktflächen 17 aufweist. Diese Kontaktflächen 17 sind über Bondverbindungen 12 mit einzelnen Kontaktinseln 7 verbunden.

Die Bondverbindungen 12 sind aus Bonddrähten 21 hergestellt und reichen von den Kontaktflächen 17 des Halbleiterchips zu einer äußeren Reihe 34 von Kontaktinseln 7 oder bis zu einem inneren Ring 37 der Kontaktflächen 7 unmittelbar in der Nachbarschaft zu dem Halbleiterchip 20. Um ein sicheres Bonden der Bonddrähte 21 auf den Oberseiten der Kontaktinseln 24 zu gewährleisten, weisen diese eine bondbare Beschichtung 25 auf. Jeder Halbleiterchip 20 ist auf nicht zu sehenden vier Chipinseln angeordnet. Er kann mit diesen Chipinseln über eine lötbare Verbindung mit seiner Rückseite verbunden sein oder auch von den Chipinseln über einen isolierenden Klebstoff isoliert sein, während er durch den isolierten Klebstoff gleichzeitig auf den Chipinseln mechanisch fixiert wird.

Aufgrund der zweireihigen Anordnung der Kontaktinseln 7 ergeben sich in jeder Bauteilposition 28 große Freiheitsgrade für den Anschluss und das Verbinden der Kontaktflächen 17 des Halbleiterchips 20 mit entsprechenden Kontaktinseln 7 des höhenstrukturierten Systemträgers 4. Die Anordnung der Halbleiterchips 20 kann variiert werden, wenn beispielsweise auf eine zweireihige Anordnung von Kontaktinseln 7 rund um den Halbleiterchip 20 verzichtet werden kann. In diesem Fall können auf der gleichen Matrix von 81 Inseln neun elektronische Bauteile 1 mit gleicher Chipgröße untergebracht werden oder vier Bauteile, jedoch mit größeren Halbleiterchips 20, die sich über sechzehn Chipinseln erstrecken, im Gegensatz zu lediglich vier Chipinseln, wie in der Ausführungsform nach Figur 1.

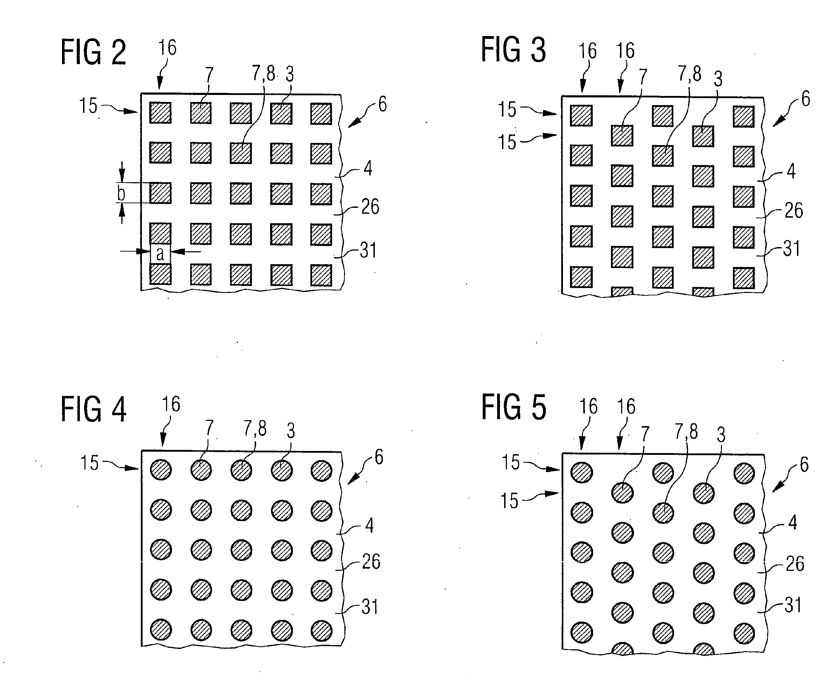

Figur 2 zeigt schematisch eine Draufsicht auf einen Ausschnitt eines höhenstrukturierten Systemträgers 4 mit in Zeilen 15 und Spalten 16 nebeneinander angeordneten höhenstrukturierten Inseln 3 mit quadratischer Grundfläche. Komponenten mit gleichen Funktionen wie in Figur 1 werden mit gleichen Bezugszeichen gekennzeichnet und nicht extra erörtert.

Bei dieser Matrix 6 von höhenstrukturierten Inseln 3 auf der Oberseite 31 eines Trägermaterials 26 eines Systemträgers 4 können nicht nur quadratische Inseln mit einer Kantenlänge a angeordnet werden, sondern auch rechteckige Kontaktinseln mit einer Breite b und einer Tiefe a, wobei die Materialstärke jeder höhenstrukturierten Insel gleich hoch ist. Die Materialstärke jeder höhenstrukturierten Insel liegt bei dieser Ausführungsform der Erfindung zwischen 1 und 50 µm.

Figur 3 zeigt schematisch eine Draufsicht auf einen Ausschnitt eines höhenstrukturierten Systemträgers 4 mit Zeilen 15 und Spalten 16 und versetzt zueinander angeordneten höhenstrukturierten Inseln 3 mit quadratischer Grundfläche. Komponenten mit gleichen Funktionen wie in den vorhergehenden Figuren werden mit gleichen Bezugszeichen gekennzeichnet und nicht extra erörtert.

Für die Kriechstromfestigkeit eines Gehäuses und für die Spannungsfestigkeit eines Gehäuses werden vorbestimmte Abstände zwischen den Außenkontakten eines elektronischen Bauteils gefordert. Eine versetzte Anordnung, wie sie in Figur 3 zu sehen ist, mit ansonsten gleichen Grundflächen der einzelnen Chipinseln hat den Vorteil, dass bei gleicher Kriechstromfestigkeit und gleicher Spannungsfestigkeit die Außenkontakte und Chipinseln wesentlich dichter in dieser Matrix 6 gepackt werden können, als im Beispiel der Figur 2.

Figur 4 zeigt schematisch eine Draufsicht auf einen Ausschnitt eines höhenstrukturierten Systemträgers 4 mit in Zeilen 15 und Spalten 16 nebeneinander angeordneten Inseln 3 mit kreisförmiger Grundfläche. Die kreisförmige Grundfläche hat den Vorteil, dass Feldstärkenspitzen vermieden werden, da die höhenstrukturierten Inseln keine Ecken aufweisen. Komponenten mit gleichen Funktionen wie in den vorhergehenden Figuren werden mit gleichen Bezugszeichen gekennzeichnet und nicht extra erörtert.

Figur 5 zeigt schematisch eine Draufsicht auf einen Ausschnitt eines höhenstrukturierten Systemträgers 4 mit in Zeilen 15 und Spalten 16 versetzt zueinander angeordneten höhenstrukturierten Inseln 3 mit kreisförmiger Grundfläche. Komponenten mit gleichen Funktionen wie in den vorhergehenden Figuren werden mit gleichen Bezugszeichen gekennzeichnet und nicht extra erörtert.

Durch die versetzte Anordnung der höhenstrukturierten Inseln mit kreisförmiger Grundfläche kann wiederum eine wesentlich verbesserte Dichte der Außenkontaktflächen bzw. der Inseln 3 erreicht werden, ohne dass dadurch die Kriechstromfestigkeit oder die Spannungsfestigkeit des elektronischen Bauteils vermindert wird.

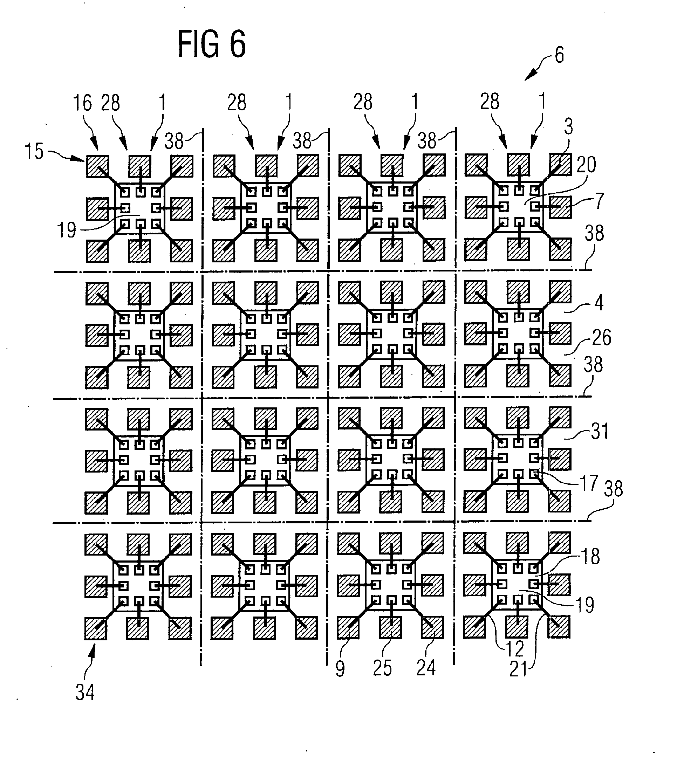

Figur 6 zeigt schematisch eine Draufsicht auf einen Ausschnitt, wie in Figur 1, mit zwölf Zeilen 15 und zwölf Spalten 16 von höhenstrukturierten Inseln 3 eines höhenstrukturierten Systemträgers 4, wobei die Inseln 3 in sechzehn Bauteilpositionen 28 eingeteilt sind, die jeweils einen Halbleiterchip 20 und einen den Halbleiterchip 20 umgebenden äußeren Ring 34 von Kontaktinseln 7 aufweisen. Komponenten mit gleichen Funktionen wie in den vorhergehenden Figuren werden mit gleichen Bezugszeichen gekennzeichnet und nicht extra erörtert.

Obgleich in Figur 6 das identische Rastermaß für die höhenstrukturierten Inseln 3 auf einem Trägermaterial 26 eines höhenstrukturierten Systemträgers 4 eingesetzt ist, können aufgrund der geringeren Fläche der Halbleiterchips 20, die in dieser Ausführungsform lediglich auf jeweils einer einzelnen Chipinsel angeordnet sind, wesentlich mehr elektronische Bauteile aufgebracht werden als bei dem Beispiel in Figur 1, bei dem einerseits zwei Ringe von Kontaktinseln vorgesehen sind und jeder Halbleiterchip 20 eine Größe aufweist, die vier Chipinseln beansprucht. Lediglich die Bauteilgrenzen, die in strichpunktierten Linien angedeutet sind, müssen bei der Ausführungsform nach Figur 6 gegenüber der Ausführungsform nach Figur 1 verschoben werden.

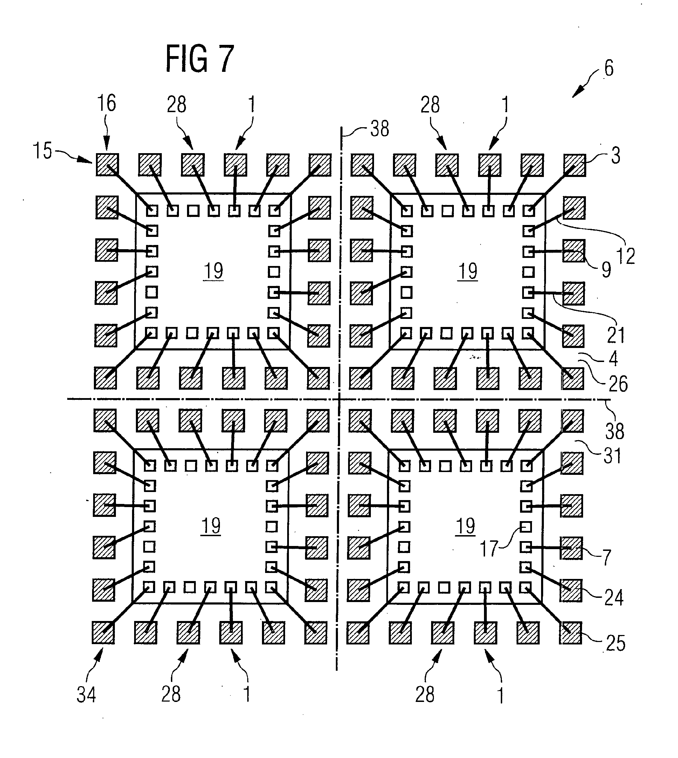

Figur 7 zeigt schematisch eine Draufsicht auf einen Ausschnitt wie in Figur 1, mit zwölf Zeilen 15 und zwölf Spalten 16 von höhenstrukturierten Inseln 3 eines höhenstrukturierten Systemträgers 4, wobei die Inseln 3 in vier Bauteilpositionen 28 eingeteilt sind, die jeweils einen Halbleiterchip 20 und einen den Halbleiterchip 20 umgebenden äußeren Ring 34 und Kontaktinseln 7 aufweisen. Komponenten mit gleichen Funktionen wie in den vorhergehenden Figuren werden mit gleichen Bezugszeichen gekennzeichnet und nicht extra erörtert.

In Figur 7 wird gezeigt, dass mit zunehmender Oberfläche 19 des Halbleiterchips 20 mehr der vorgesehenen höhenstrukturierten Inseln als Chipinseln eingesetzt werden. Bei dem hier vorliegendem Beispiel in Figur 7 sind insgesamt 16 der höhenstrukturierten Inseln 3 als Chipinseln zur Aufnahme des Halbleiterchips 20 eingesetzt, so dass bei gleichbleibender Anzahl von 81 höhenstrukturierten Inseln dieses Ausschnittes eines Systemträgers 4 nur noch vier elektronische Bauteile utergebracht werden können, die jeweils einen umgebenden Ring 34 aus Kontaktinseln 7 aufweisen.

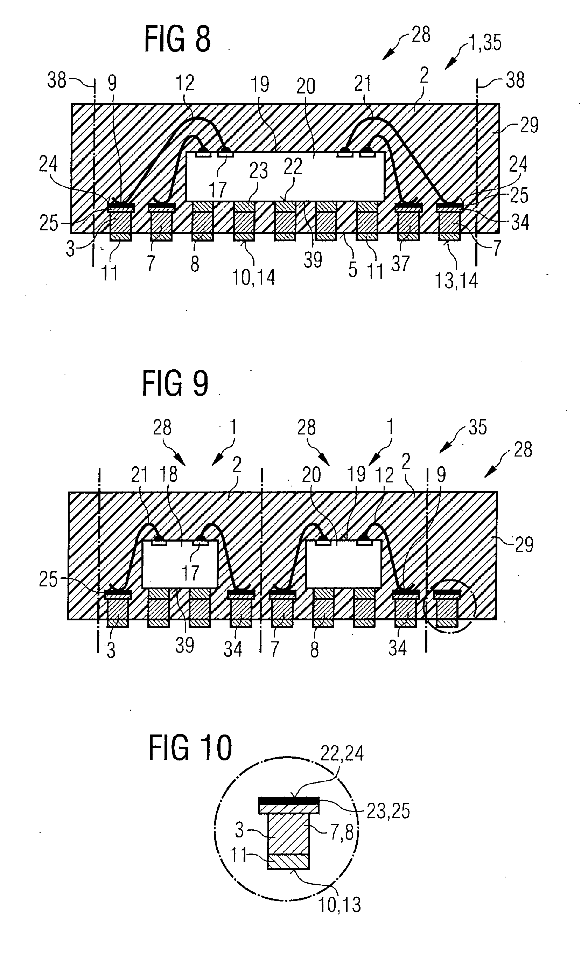

Figur 8 zeigt einen schematischen Querschnitt durch ein elektronisches Bauteil 1 mit einem Kunststoffgehäuse 2 und 81 höhenstrukturierten Inseln 3, bei dem ein Halbleiterchip 20 auf 25 Chipinseln 8 angeordnet ist und der Halbleiterchip 20 von zwei Ringen 34 und 37 aus insgesamt 56 Kontaktinseln 7 umgeben ist. Darüber hinaus zeigt Figur 8, dass die Chipinseln 8 unter dem Halbleiterchip 20 auf ihrer Oberseite 23 eine lötbare Beschichtung aufweisen, die mit der Rückseite 39 des Halbleiterchips 20 elektrisch und mechanisch verbunden sind. Durch diese Verbindung ist der Halbleiterchip 20 auf den Chipinseln 8 fixiert und kann vor dem Verpacken in einer Kunststoffpressmasse 29 über Bondverbindungen 12 mit den Kontaktinseln 7 verbunden werden. Dazu weisen die Kontaktinseln 7 auf ihrer Oberseite 24 eine bondbare Beschichtung 25 auf.

Die strichpunktierten Linien in Figur 8 kennzeichnen oder markieren die Gehäusegrenzen 38 einer Bauteilposition 28. Auf der Unterseite der Chipinseln 8 sind ebenfalls lötbare Beschichtungen aufgebracht, die für eine Verbindung zu einem übergeordneten System, beispielsweise einer Leiterplatte, vorgesehen sind. Dazu ist das Rastermaß auf der Leiterplatte dem Rastermaß des Halbleiterchips 20 oder umgekehrt angepasst. Unter der Voraussetzung, dass der Halbleiterchip 20 quadratisch ist, stützt er sich auf 25 Chipinseln ab und ist von 56 Kontaktinseln umgeben. Wenn die Anzahl der Kontaktflächen 17 auf der aktiven Oberseite 19 des Halbleiterchips geringer ist als 56, so ist auch ein rechteckförmiges Bauteil denkbar, bei dem jeweils nur an den zwei Querseiten des elektronischen Bauteils 1 zwei Reihen von Kontaktinseln 7 angeordnet sind. Bei einer derartigen Ausführungsform der Erfindung würde in Figur 8 eine Anzahl von lediglich 20 Kontaktinseln für den Anschluss der Kontaktflächen 17 über Bonddrähte 21 zur Verfügung stehen. Das Breiten-zu-Längen-Verhältnis eines derartigen Bauteils wäre dann 5 : 9.

Figur 9 zeigt einen schematischen Querschnitt durch einen Ausschnitt eines Nutzens 35 mit 64 höhenstrukturierten Inseln 3, bei dem in vier Bauteilpositionen 28 jeweils ein Halbleiterchip 20 auf vier Chipinseln angeordnet ist und jedes Halbleiterchip 20 von sechzehn Kontaktinseln 7 umgeben ist. Komponenten mit gleichen Funktionen wie in den vorhergehenden Figuren werden mit gleichen Bezugszeichen gekennzeichnet und nicht extra erörtert.

Bei der Angabe der Kontaktinseln und der Chipinseln wird vorausgesetzt, dass auch hier ein Halbleiterchip 20 eingesetzt ist, der einen quadratischen Querschnitt aufweist und eine entsprechende Anzahl von Kontaktflächen 17 besitzt, die einen vollständigen Ring 34 von Kontaktinseln 7 um jeden Halbleiterchip 20 herum benötigt. Bei einem Halbleiterchip 20 eines Hochfrequenztransistor würden jedoch wesentlich weniger Kontaktinseln ausreichen, um den Hochfrequenztransistor ansteuern zu können, so dass in dem Fall eine rechteckförmiges Ausgestaltung des elektronischen Bauteils 1 eine bessere Raumnutzung ergebe. In dem Fall könnten einseitig eine Reihe von nur zwei Kontaktflächen 7 vorgesehen werden, die den Basis- und den Emitteranschluss darstellen, während die Chipinseln 8 den Kollektoranschluss verwirklichen. In einer derartigen Ausführungsform, die ähnlich wie Figur 9 aussieht, wären insgesamt nur sechs Chipinseln 8 erforderlich, nämlich vier Chipinseln zum Fixieren des Hochfrequenztransistors und zum elektrischen Anschließen des Kollektors und auf einer der Seiten zwei Kontaktinseln in einer Reihe zum Anschluss von Basis und Emitter, so dass das Seiten-zu-Längen-Verhältnis eines solchen Bauelementes 2 : 3 wäre. Sind anstelle von lediglich zwei Kontaktflächen vier Kontaktflächen erforderlich, so kann das Breiten-zu-Längen-Verhältnis 2 : 4 realisiert werden.

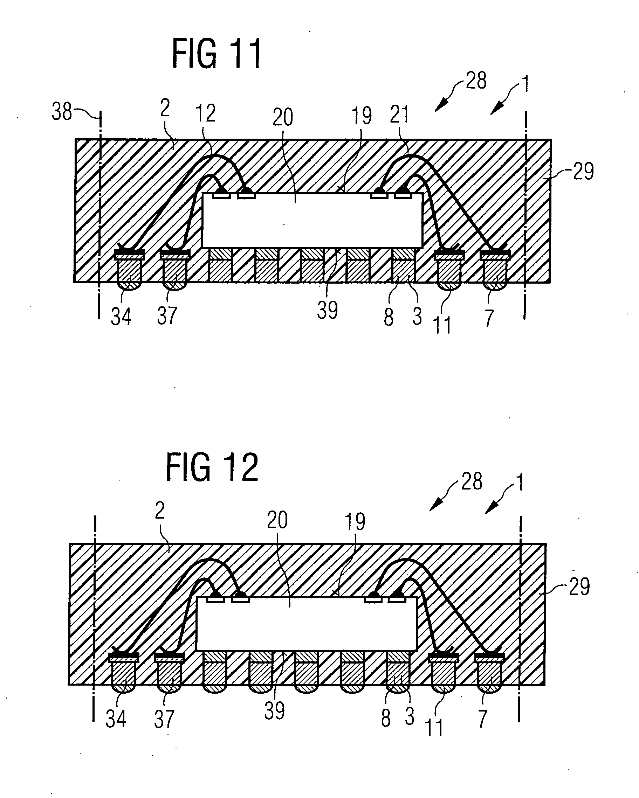

Figur 10 zeigt einen schematischen Querschnitt durch eine höhenstrukturierte Insel 3 mit Beschichtungen auf ihrer Oberseite 22 oder 24 und ihrer Unterseite 10 oder 13. Komponenten mit gleichen Funktionen wie in den vorhergehenden Figuren werden mit gleichen Bezugszeichen gekennzeichnet und nicht extra erörtert.

Das Besondere dieser höhenstrukturierten Insel 3 ist, dass sie nagelkopfförmig oder pilzförmig ausgebildet ist, das heißt auf der Oberseite eine breitere Struktur aufweist als auf der Unterseite. Dieses hat den Vorteil, dass die höhenstrukturierte Chipinsel 3 formschlüssig in der Kunststoffpressmasse 29 bzw. in dem Kunststoffgehäuse 2 verankert werden kann. Diese Verankerung kann dadurch noch verbessert werden, dass beispielsweise die freien Seitenflächen mit einem Haftvermittler aus Keramikkristallen beschichtet werden, so dass die Verankerung mit der Kunststoffpressmasse 29 weiter verbessert ist. Die Beschichtung auf der Oberseite der höhenstrukturierten Insel 3 hängt von der Funktion der Insel ab und ist eine bondbare Beschichtung, wenn es sich bei der Insel um eine Kontaktinsel 7 handelt und eine lötbare oder klebbare Beschichtung, wenn die höhenstrukturierte Insel 3 eine Chipinsel 8 ist.

Figur 11 zeigt einen schematischen Querschnitt durch ein elektronisches Bauteil 1, wie es in Figur 8 gezeigt wird. Komponenten mit gleichen Funktionen wie in den vorhergehenden Figuren werden mit gleichen Bezugszeichen gekennzeichnet und nicht extra erörtert.

Der Unterschied des elektronischen Bauteils in Figur 11 zum elektronischen Bauteil in Figur 8 besteht darin, dass auf der Unterseite der höhenstrukturierten Chipinseln 7 keine flachen Außenkontakte hergestellt sind, sondern Lotdepots für die Kontaktringe 34 und 37 angebracht wurden und gleichzeitig die Chipinseln 8 unterhalb des Halbleiterchips 20 ohne jedes Lotdepot hergestellt sind. In einem derartigen Fall, in dein kein Außenkontakt zu der Chipinsel zu verwirklichen ist, kann der Halbleiterchip 20 auf den Chipinseln 8 mit Hilfe eines isolierenden Klebstoffes fixiert werden, um ihn während des Bondvorgangs an Positionsänderungen zu hindern.

Figur 12 zeigt einen schematischen Querschnitt durch ein elektronisches Bauteil 1, wie in Figur 8 und in Figur 11. Komponenten mit gleichen Funktionen wie in den vorhergehenden Figuren werden mit gleichen Bezugszeichen gekennzeichnet und nicht extra erörtert.

Der Unterschied des elektronischen Bauteils 1 der Figur 12 zum elektronischen Bauteil 1 der Figur 8 besteht darin, dass die höhenstrukturierten Inseln auf ihrer Unterseite in Figur 12 mit einem Lotdepot versehen sind, während sie in Figur 8 mit einer flachen lötbaren Beschichtung ausgestattet sind. Zum vorhergehenden Beispiel der Figur 11 hat dieses elektronische Bauteil der Figur 12 auch Lotdepots für die Chipinseln vorgesehen, so dass die Chipinsel entweder auf ein Bezugspotential gelegt werden kann oder zumindest eine bessere Wärmeabfuhr für den Halbleiterchip 20 sichergestellt wird.

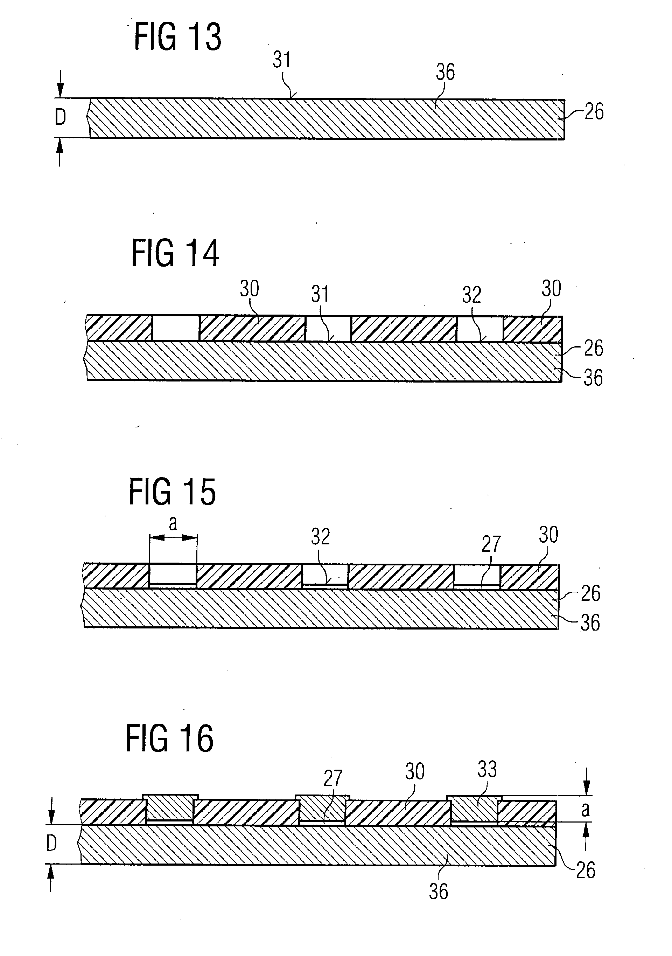

Die Figuren 13 bis 19 zeigen schematisch im Querschnitt eine schrittweise Herstellung eines Systemträgers 4, eines Nutzens 35 und eines elektronischen Bauteils 1 mit höhenstrukturierten Inseln 3. Komponenten mit gleichen Funktionen wie in den vorhergehenden Figuren werden mit gleichen Bezugszeichen gekennzeichnet und nicht extra erörtert.

Figur 13 zeigt einen Querschnitt durch eine Metallplatte 36 oder eine Metallfolie, die als Trägermaterial 26 in einer Dicke D zum Aufbau eines Systemträgers mit höhenstrukturierten Inseln sowie eines Nutzens und schließlich eines elektronischen Bauteils zur Verfügung gestellt wird. Die Metallplatte 36 weist eine Oberseite 31 auf, die vollständig planer ist. Die Metallplatte 36 selbst weist Kupfer oder eine Kupferlegierung in dieser Ausführungsform der Erfindung auf.

Figur 14 zeigt im Querschnitt das Trägermaterial 26, wie es in Figur 13 dargestellt ist, das auf seiner Oberseite 31 eine strukturierte Maske 30 aufweist. Diese strukturierte Maske 30 wurde in dieser Ausführungsform mit Hilfe eines Photolackschrittes aufgebracht, wobei der Photolack in dieser Ausführungsform der Erfindung im Bereich von 1 bis 50 µm dick ist. Diese Photolackschicht 30 weist freiliegende Flächen 32 innerhalb der Maske auf, die zur Herstellung von Kontaktinseln und Chipinseln vorgesehen sind.

Figur 15 zeigt im Querschnitt das Trägermaterial 26, wie in den vorhergehenden Figuren und in den freiliegenden Flächen 32 auf der Oberseite 31 des Trägermaterials 26 eine erste galvanisch abgeschiedene Beschichtung in Form einer Ätzstoppzone 27 auf. Diese Ätzstoppzone 27 weist eine Nickellegierung auf, die in einem entsprechenden galvanischen Bad unter Anlegen eines negativen Potentials auf dem Trägermaterial 26 abgeschieden wurde.

Figur 16 zeigt einen Querschnitt durch das Trägermaterial 26 mit aufgefüllten Bereichen der freiliegenden Flächen 32 der Figur 6. Auf der Ätzstoppzone 27 wurde zwischenzeitlich eine höhenstrukturierte Schicht 33 abgeschieden. Diese Schicht 33 weist eine Kupferlegierung auf und wurde in einem Elektrolytbad, das im wesentlichen Kupfervitriol enthält, hergestellt. Dabei wurde der galvanische Abscheideprozess so lange fortgesetzt, bis die höhenstrukturierte Schicht 30 mit ihrer Materialstärke d die Dicke der Ätzmaske 30 übersteigt.

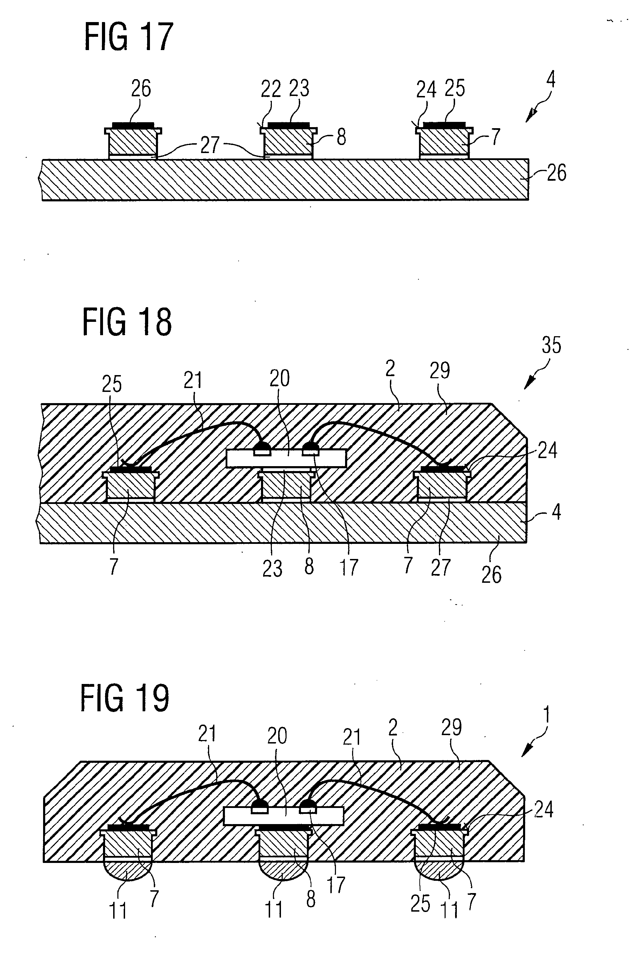

Figur 17 zeigt einen Querschnitt durch einen fertiggestellten Systemträger 4 mit höhenstrukturierten Komponenten 3, nachdem die Maske 30, die in den vorhergehenden Figuren 14 und 15 gezeigt wurde, entfernt ist. Von diesem Systemträger 4 mit höhenstrukturierten Inseln 3 werden in das elektronische Bauteil lediglich die höhenstrukturierten Inseln eingebaut. Dabei bestehen die höhenstrukturierten Inseln aus einer Matrix von Kontaktinseln 7 und Chipinseln 8. Ferner sind in Figur 17 zwei weitere Verfahrensschritte durchgeführt, wobei auf der Oberseite 24 der Kontaktinsel 7 eine bondbare Beschichtung 35 aufgebracht ist und danach auf der Chipinsel 8 eine lötbare Beschichtung 23 hergestellt ist. Diese Lotschicht 23 ist in dieser Ausführungsform ein Silberlot und kann jedoch auch ein leitfähiger Klebstoff sein, der elektrisch die Rückseite des Halbleiterchips mit der Chipinsel 8 verbindet.

Figur 18 zeigt einen Querschnitt durch einen Nutzen 35, der im wesentlichen aus einem Systemträger 4 mit höhenstrukturierten Inseln 3 und einem aktiven Schaltungselement in einem Kunststoffgehäuse 2 besteht. Das Schaltungselement ist ein Halbleiterchip 20 mit Kontaktflächen 17 auf seiner aktiven Oberseite, die über Bonddrähte 21 mit den bondbaren Beschichtungen auf den Kontaktinseln 7 verbunden sind. Somit kann über die Kontaktinseln 7 und die Bonddrähte 21 auf das elektronische Schaltungselement zugegriffen werden. Das Kunststoffgehäuse 2 ist eine Platte aus einer Kunststoffpressmasse 29, die sich über mehrere Bauteilpositionen 28 eines Nutzens 35 erstreckt. Somit stellt der Nutzen 35 einen Verbund von Systemträger und Kunststoffpressmasse dar, wobei die Kunststoffpressmasse 29 die höhenstrukturierten Kontaktinseln 7 und die höhenstrukturierten Chipinseln 8 sowie die Bondverbindungen 12 einschließt. Eine derartige Verbundplatte ist äußerst stabil und folglich lagerfähig und kann als Zwischenprodukt kommerziell verwertet werden.

Figur 19 zeigt einen Querschnitt durch ein elektronisches Bauteil 1 mit einem Halbleiterchip 20, nachdem das Trägermaterial 26, das noch in Figur 18 mit dem Nutzen 35 verbunden war, von der Unterseite des Nutzens entfernt worden ist. Die nun freiliegenden Unterseiten der Kontaktinseln 7 und der Chipinseln 8 können mit einer Lotbeschichtung oder mit einem Lotdepot versehen werden, so dass die elektronischen Bauteile 1 mit einer Matrix von Außenkontakten 11 auf ihren Unterseiten ausgestattet sind. Anschließend kann der Nutzen in einzelne elektronische Bauteile aufgetrennt werden.

### Bezugszeichenliste

- 1: elektronisches Bauteil
- 2: Kunststoffgehäuse
- 3: höhenstrukturierte Inseln
- 4: höhenstrukturierter Systemträger
- 5: Unterseite des elektronischen Bauteils
- 6: Matrix von Kontaktinseln und Chipinsel
- 7: Kontaktinsel
- 8: Chipinsel
- 9: Bondanschlüsse auf Kontaktinseln
- 10: Unterseite der Chipinsel
- 11: Außenkontaktflächen
- 12: Bondverbindungen
- 13: Unterseite der Kontaktinseln
- 14: Außenflächen der Kontaktinseln und/oder der Chipinseln
- 15: Zeilen
- 16: Spalten
- 17: Kontaktflächen der Halbleiterchips
- 18: Schaltungselemente
- 19: Oberseite der Halbleiterchips
- 20: Halbleiterchips
- 21: Bonddrähte
- 22: Oberseite der Chipinseln
- 23: lötbare Beschichtung
- 24: Oberseite der Kontaktinseln
- 25: bondbare Beschichtung
- 26: Trägermaterial
- 27: Ätzstoppzone
- 28: Bauteilpositionen
- 29: Kunststoffpressmasse
- 30: Maske auf Trägermaterial
- 31: Oberseite des Trägermaterials
- 32: freiliegende Flächen
- 33: höhenstrukturierte Schicht
- 34: äußerer Ring aus Kontaktinseln
- 35: Nutzen
- 36: Metallplatte
- 37: innerer Ring aus Kontaktinseln
- 38: Bauteilgrenzen
- 39: Rückseite
- 40: Lotdepot
- a: Tiefe der Inseln
- b: Breite der Inseln
- d: Materialstärke der höhenstrukturierten Inseln
- D: Materialstärke des Trägermaterials

## Patentansprüche

1. Elektronisches Bauteil mit einem Kunststoffgehäuse (2), wobei das Kunststoffgehäuse (2) Inseln (3) eines höhenstrukturierten Systemträgers (4) aufweist, und diese höhenstrukturierten Inseln (3) auf der Unterseite (5) des Kunststoffgehäuses (2) in einer Matrix (6) angeordnet sind und Chipinseln (8) aufweisen, auf denen ein Halbleiterchip angeordnet ist, und Kontaktinseln (7) aufweisen, die Bondanschlüsse (9) auf ihren Oberseiten (24) und Außenkontaktflächen (11) auf ihren Unterseiten (13) aufweisen.

2. Elektronisches Bauteil nach Anspruch 1,
**dadurch gekennzeichnet, dass**
die Inseln (3) in der Matrix (6) unter- und nebeneinander oder versetzt zueinander in Zeilen (15) und Spalten (16) angeordnet sind.

3. Elektronisches Bauteil nach einem der vorhergehenden Ansprüche,
**dadurch gekennzeichnet, dass**
die Inseln (3) jeweils gleiche Abmessungen im Hinblick auf Materialstärke (d), Breite (b) und Tiefe (a) aufweisen.

4. Elektronisches Bauteil nach einem der vorhergehenden Ansprüche,
**dadurch gekennzeichnet, dass**
die Inseln (3) eine zylindrische Struktur oder einen polygonalen Querschnitt aufweisen.

5. Elektronisches Bauteil nach einem der vorhergehenden Ansprüche,
**dadurch gekennzeichnet, dass**
die Inseln (3) zur Unterseite (5) des elektronischen Bauteils (1) hin einen sich vermindernden Querschnitt aufweisen.

6. Elektronisches Bauteil nach einem der vorhergehenden Ansprüche,
**dadurch gekennzeichnet, dass**
die Inseln (3) Kupfer, Nickel, Silber oder Legierungen derselben aufweisen.

7. Elektronisches Bauteil nach einem der vorhergehenden Ansprüche,
**dadurch gekennzeichnet, dass**
die Oberseite (24) jeder Kontaktinsel (7) eine bondbare Beschichtung (17) aufweist, insbesondere mit Gold, Palladium, Silber, Aluminium und/oder Legierungen derselben.

8. Elektronisches Bauteil nach einem der vorhergehenden Ansprüche,
**dadurch gekennzeichnet, dass**
die Oberseiten (22) der Chipinseln (8) eine lötbare Beschichtung (19) aufweisen, insbesondere mit Silberlot.

9. Elektronisches Bauteil nach einem der vorhergehenden Ansprüche,
**dadurch gekennzeichnet, dass**
auf einzelnen Chipinseln (8) Halbleiterchips (20) von diskreten Hochfrequenz- oder Niederfrequenzbeuelementen angeordnet sind.

10. Elektronische Bauteil nach einem der vorhergehenden Ansprüche,
**dadurch gekennzeichnet, dass**
mehrere Chipinseln (8) einen großflächigen Halbleiterchip (20) für Logik- und Speicheranwendungen auf ihren Oberseiten (22) aufweisen.

11. Elektronische Bauteil nach einem der vorhergehenden Ansprüche,
**dadurch gekennzeichnet, dass**
der auf Chipinseln (8) angeordnete Halbleiterchip (20) mindestens von einer Reihe einseitig oder von einem Ring (34) allseitig aus Kontaktinseln (7) umgeben ist, wobei Bonddrähte (21) Kontaktflächen (17) auf der aktiven Oberseite (19) des Halbleiterchips (20) mit den Oberseiten (24) der umgebenden Kontaktinseln (7) elektrisch verbinden.

12. Systemträger zum Aufbau eines elektronischen Bauteils nach einem der vorhergehenden Ansprüche,
**dadurch gekennzeichnet, dass**
der Systemträger (4) zwischen den höhenstrukturierten Inseln (3) und einem Trägermaterial (26) eine Trennschicht (27) vorzugsweise eine Ätzstoppzone (27) aus Nickel oder eine Nickellegierung aufweist.

13. Systemträger nach Anspruch 15 oder Anspruch 16,
**dadurch gekennzeichnet, dass**
der Systemträger (4) in mehrere Bauteilpositionen (28) einteilbar ist, deren Anzahl und Größe an die Größe des Halbleiterchips (20) und an die Anzahl der auf dem Halbleiterchip (20) angeordneten Kontaktflächen (37) anpassbar ist.

14. Nutzen, der mehrere in einer gemeinsamen Kunststoffpressmasse (29) angeordnete elektronische Bauteile (1) aufweist, wobei jedes Bauteil (1) Inseln (3) eines höhenstrukturierten Systemträgers (4) aufweist und diese Inseln (3) eine Matrix (6) aus Kontaktinseln (7) und Chipinseln (8) aufweisen, wobei die Chipinseln (8) elektronische Schaltungselemente (18) tragen und die Kontaktinseln (7) mit den Chipinseln (8) und/oder untereinander über Bondverbindungen (12) innerhalb der Kunststoffpressmasse (29) verbunden sind, und wobei die Kunststoffpressmasse (19) und der höhenstrukturierte Systemträger (4) eine kompakte Verbundplatte mit darin angeordneten elektronischen Bauteilen bilden.

15. Verfahren zur Herstellung eines Systemträgers mit höhenstrukturierten Inseln, das folgende Verfahrensschritte aufweist:
- Bereitstellen eines Trägermaterials (26) für einen höhenstrukturierten Systemträger (4) in Form einer Platte oder eines Bandes,
- Bilden von höhenstrukturierten Inseln auf dem Trägermaterial in einer Matrix mit einheitlichem Rastermaß.

16. Verfahren zur Herstellung eines Systemträgers mit höhenstrukturierten Inseln, das zum Bilden der Inseln folgende Verfahrensschritte aufweist:
- Aufbringen einer Maske (30) auf einer Oberseite (31) eines metallischen Trägermaterials (26) mit einer Matrix (6) aus freiliegenden Flächen (32) des Trägermaterials (31) für höhenstrukturierte in Zeilen und Spalten angeordnete Inseln,
- Aufbringen einer höhenstrukturierten Schicht mit Ätzstoppzone auf die freiliegenden Flächen des Trägermaterials unter Ausbildung von höhenstrukturierten Inseln eines Systemträgers einschließlich einer abschließenden bondbaren Beschichtung,
- Entfernen der Maske (30).

17. Verfahren zur Herstellung eines Nutzens aus einem Verbund aus Systemträger mit höhenstrukturierten Inseln und einer Kunststoffpressmasse das folgende Verfahrensschritte aufweist:
- Bereitstellen eines metallischen Trägermaterials (26) für einen höhenstrukturierten Systemträger (4) in Form einer Metallplatte oder eines Metallbandes,
- Aufbringen einer Maske (30) auf einer Oberseite (31) des Trägermaterials (26) mit einer Matrix (6) aus freiliegenden Flächen (32) des Trägermaterials (31) für höhenstrukturierte in Zeilen und Spalten angeordnete Inseln,
- Aufbringen einer höhenstrukturierten Schicht mit Ätzstoppzone auf die freiliegenden Flächen des Trägermaterials unter Ausbildung von höhenstrukturierten Inseln eines Systemträgers einschließlich einer abschließenden bondbaren Beschichtung,
- Entfernen der Maske (30),
- Aufbringen einer lötbaren Beschichtung (23) oder eines Leitklebstoffs auf Chipinseln (8),
- Aufbringen von Halbleiterchips (20) auf die Chipinseln (18),
- Herstellen von Bondverbindungen (12) zwischen Kontaktflächen des Halbleiterchips und Kontaktinseln (7) und/oder zwischen Kontaktinseln (7),
- einseitiges Verpacken des Systemträgers für mehrere elektronische Bauteile in einer gemeinsamen Schicht aus Kunststoffpressmasse (29) unter Einbetten der höhenstrukturierten Inseln (3)und der Bondverbindungen (12) in der Kunststoffpressmasse (29) zu einem Nutzen.

18. Verfahren zur Herstellung eines elektronischen Bauteils mit einem Kunststoffgehäuse (2) und Inseln (3) eines höhenstrukturierten metallischen Systemträgers (4), wobei das Verfahren folgende Verfahrensschritte aufweist:
- Bereitstellen eines metallischen Trägermaterials (26) für einen höhenstrukturierten Systemträger (4) in Form einer Metallplatte oder eines Metallbandes,
- Aufbringen einer Maske (30) auf einer Oberseite (31) des Trägermaterials (26) mit einer Matrix (6) aus freiliegenden Flächen (32) des Trägermaterials (31) für höhenstrukturierte in Zeilen und Spalten angeordnete Inseln,
- Aufbringen einer höhenstrukturierten Schicht mit Ätzstoppzone auf die freiliegenden Flächen des Trägermaterials unter Ausbildung von höhenstrukturierten Inseln eines Systemträgers einschließlich einer abschließenden bondbaren Beschichtung,
- Entfernen der Maske (30),
- Aufbringen einer lötbaren Beschichtung (23) oder eines Leitklebstoffs auf Chipinseln (8),
- Aufbringen von Halbleiterchips (20) auf die Chipinseln (18),
- Herstellen von Bondverbindungen (12) zwischen Kontaktflächen des Halbleiterchips und Kontaktinseln (7) und/oder zwischen Kontaktinseln (7),
- einseitiges Verpacken des Systemträgers für mehrere elektronische Bauteile in einer gemeinsamen Schicht aus Kunststoffpressmasse (29) unter Einbetten der höhenstrukturierten Inseln (3)und der Bondverbindungen (12) in der Kunststoffpressmasse (29) zu einem Nutzen,
- Entfernen des Systemträgers (4) mindestens bis zur Ätzstoppzone (27),
- Aufbringen einer Kontaktschicht auf die Unterseiten der Inseln zur Bildung von Außenkontakten auf der Unterseite des elektronischen Bauteils,
- Trennen des Nutzens (4) mit Kunststoffpressmasse und höhenstrukturierten Inseln eines Systemträgers in einzelne elektronische Bauteile (1).

19. Verfahren nach einem der Ansprüche 15 bis 18,
**dadurch gekennzeichnet, dass**
das Aufbringen einer Maske (30) mittels Photolithographie oder mittels Drucktechnik vorzugsweise Siebdrucktechnik oder Schablonendrucktechnik erfolgt.

20. Verfahren nach einem der Ansprüche 15 bis 19,
**dadurch gekennzeichnet, dass**
das Aufbringen einer Ätzstoppzone (27) mittels Aufstäubungstechnik (Sputtertechnik), Aufdampftechnik oder chemischer Gasphasenabscheidung erfolgt.

21. Verfahren nach einem der Ansprüche 15 bis 20,
**dadurch gekennzeichnet, dass**
das Aufbringen einer Ätzstoppzone (27) und/oder einer höhenstrukturierten Schicht (33) auf die Ätzstoppzone (27) in den freiliegenden Flächen (32) des Trägermaterials (26) mittels galvanischer Abscheidung erfolgt.

22. Verfahren nach einem der Ansprüche 15 bis 21,
**dadurch gekennzeichnet, dass**
das Entfernen der Maske (30) durch chemische Lösungsmittel oder einen Plasmaveraschungsprozess erfolgt.

23. Verfahren nach einem der Ansprüche 15 bis 22,
**dadurch gekennzeichnet, dass**
das Aufbringen einer bondbaren Beschichtung (25) auf Kontaktinseln (7) mittels Aufstäubungstechnik erfolgt.

24. Verfahren nach einem der Ansprüche 15 bis 23,
**dadurch gekennzeichnet, dass**
das Aufbringen eines Leitklebstoffs mittels Klebstofffolien, Drucktechniken oder Aufspritzen erfolgt.

25. Verfahren nach einem der Ansprüche 15 bis 24,
**dadurch gekennzeichnet, dass**
das Herstellen von Bondverbindungen (12) mittels Thermokompressions-, Thermosonic- oder Ultraschallbonden erfolgt.

26. Verfahren nach einem der Ansprüche 15 bis 25,
**dadurch gekennzeichnet, dass**
das Verpacken in einer Kunststoffpressmasse (29) mittels Spritzgusstechnik oder Druckgusstechnik erfolgt.
